Europäisches Patentamt

European Patent Office

Office européen des brevets

(19)

(11) Veröffentlichungsnummer: **0 141 245 B1**

(12) **EUROPÄISCHE PATENTSCHRIFT**

(45) Veröffentlichungstag der Patentschrift: **02.10.91**

(51) Int. Cl.5: **H04Q 3/545**, G06F 11/20

(21) Anmeldenummer: **84111428.3**

(22) Anmeldetag: **25.09.84**

(54) **Verfahren zum Betrieb eines in Normalbetriebszeit parallel betriebenen Speicherblockpaares.**

(30) Priorität: 26.09.83 DE 3334773

(43) Veröffentlichungstag der Anmeldung:
**15.05.85 Patentblatt 85/20**

(45) Bekanntmachung des Hinweises auf die
Patenterteilung:
**02.10.91 Patentblatt 91/40**

(84) Benannte Vertragsstaaten:
**AT BE CH DE FR GB IT LI NL SE**

(56) Entgegenhaltungen:
**US-A- 3 882 455
US-A- 4 371 754**

**IBM TECHNICAL DISCLOSURE BULLETIN,
Band 10, Nr. 8, Januar 1968, Seiten
1098-1100, New York, US; N.I. HANSON et al.:
"Data processing unit"**

**Bell-Northern Research publication, Seiten
234-239; N. Balatoni: "How a computercontrolled swiching machine spends its
time", October 1976, Ottawa, CA**

**ITC-9, A. Bricolli: "Comparison of regulation
methods for traffic overloads in SPC systems", October 1979, Torremolinos, ES**

(73) Patentinhaber: **Siemens Aktiengesellschaft
Wittelsbacherplatz 2
W-8000 München 2(DE)**

(72) Erfinder: **Bitzinger, Rudolf, Dipl.-Ing.
Lechbrucker Strasse 11
W-8000 München 71(DE)**
Erfinder: **Engl, Walter, Dipl.-Ing.
Am Kellerberg 4
W-8152 Feldkrichen-W.(DE)**
Erfinder: **Humml, Siegried, Ing.
An der Freiheit 130
W-8122 Penzberg(DE)**
Erfinder: **Schreier, Klaus, Dipl.-Ing.
Nonnenwaldstrasse 8a
W-8122 Penzberg(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren gemäß dem Oberbegriff des Patentanspruches 1.

Ein solches Verfahren ist aus IBM, TDB, Vol. 10, Nr. 8. Jan. 1968, Seiten 1098 bis 1100 bekannt.

Bei diesem Verfahren liegt gegen Ende einer Sonderbetriebszeit, in der einer der Speicher des während der Normalbetriebszeit mikrosynchron parallel betriebenen Speicherblockpaares in der Weise abgetrennt ist, daß ein Zugriff eines Prozessors zum Zwecke des Lesens ausgeschlossen ist, ein gleichzeitiger Ablauf zweier Aktualisierungsvorgänge mit dem Ziel vor, den Inhalt der Speicher für die Wiederaufnahme des Betriebs in der Normalbetriebszeit auf identischen Stand zu bringen. Der eine Ablauf besteht darin, daß bei einem Einschreiben in den nicht abgetrennten ersten Speicher schon wieder unter derselben Adresse in den zweiten Speicher eingeschrieben wird, wogegen der andere Ablauf in einem aufgrund systematischer Adressenansteuerung erfolgenden Auslesen von Informationen aus dem ersten Speicher und Einschreiben derselben unter der entsprechenden Adresse in den zweiten Speicher besteht. Auf diese Art und Weise kann zwar erreicht werden, daß eine Übereinstimmung der Speicherinhalte der beiden Speicher auch ohne Unterbrechung des laufenden Betriebs während der gesamten Zeit der Aktualisierung hergestellt wird, eine Beeinträchtigung des laufenden Betriebs kann hierbei jedoch nicht vollständig ausgeschlossen werden.

Bei einem aus dem US-Patent 4 3871 754 bekannten Verfahren ist zwar eine solche Beeinträchtigung des Normalbetriebs dadurch weitgehend vermieden, daß ein Zugriff auf Speicherplätze des zweiten Speichers, dessen Inhalt zu aktualisieren ist, jeweils nur im Zusammenhang mit denjenigen Teilen des Speichers erfolgt, auf dessen entsprechenden Teil des ersten Speichers im Augenblick kein Zugriff vorliegt. Zur Durchführung dieses Verfahrens ist allerdings ein entsprechender Steuerungsaufwand erforderlich.

Aus der Zeitschrift Bell-Northern Research, Oktober 1976, Seiten 234 bis 39 sowie aus dem Aufsatz von A. Bricolli "Comparision Of Regulation Methods For Graphic Overloads In SPC-Systems" in ITC 9, Oktober 1979, Torremolinos, Spanien, ist es bekannt, Aufgaben unterschiedlicher Priorität in der Weise durchzuführen, daß zunächst immer die Aufgaben vorrangiger Wichtigkeit zu ihrem Abschluß ausgeführt werden und dann erst Aufgaben mit geringerer Wichtigkeit in Angriff genommen werden. Bei den Aufgaben unterschiedlicher Wichtigkeit handelt es sich um solche, die unterschiedlichen Zwecken dienen, nämlich bei Aufgaben mit höchster Priotität beispielsweise um solche, die mit einer Fernsprechverbindungsherstellung in Zusammenhang stehen, bei solchen niedrigster Priorität beispielsweise um Eigenprüfungen.

Die Aufgabe der Erfindung besteht nun darin, ein im Oberbegriff des Patentanspruchs angegebenes Verfahren so weiterzubilden, daß die Aktualisierung des Speicherinhalts des abgetrennten Speicherblockes eines Speicherblockpaares ohne Behinderung des anderen Speicherblockes durchgeführt werden kann.

Diese Aufgabe wird durch die im Patentanspruch genannten Maßnahmen gelöst.

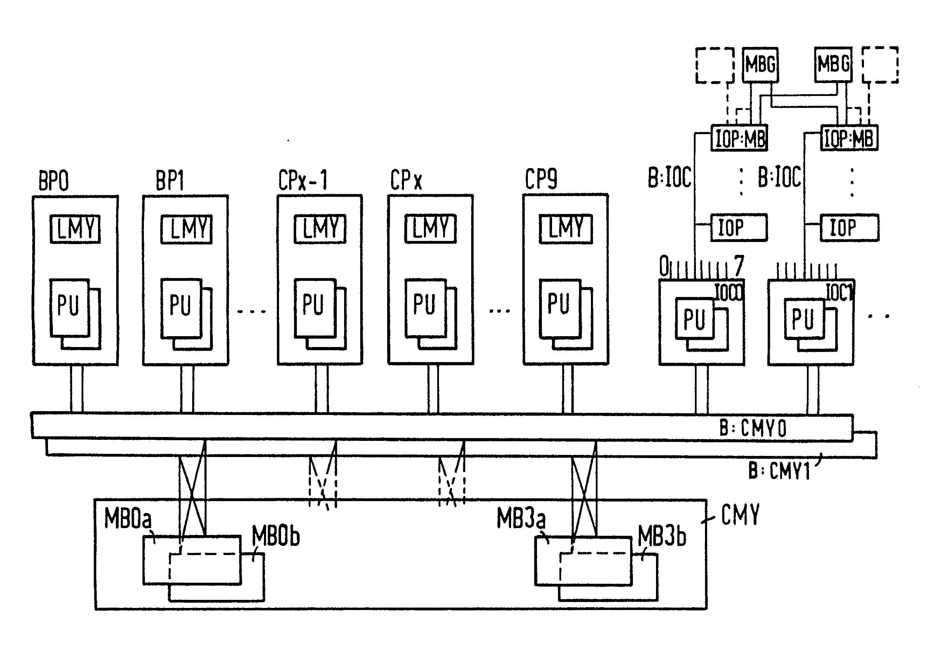

Die Erfindung wird anhand von einem Ausführungsbeispiel näher erläutert, welches in der Figur gezeigt ist.

Die Figur zeigt eine Zentralsteuereinheit, bei der zwölf Prozessoren BP/CP, sowie mehrere Prozessoren IOC über das Bussystem B:CMY mit dem Hauptspeicher CMY zusammenarbeiten.An sich können alle Prozessoren BP/CP untereinander gleich aufgebaut sein und im Prinzip auch alle dieselben Aufgabenkomplexe bearbeiten. Durch die unterschiedlichen Hinweiszeichen BP/CP wird aber angedeutet, daß an sich auch unterschiedliche Aufbauten und/oder Aufgabenkomplexe zugelassen sind - auch dann ist das erfindungsgemäße Verfahren anwendbar.

Die Prozessoren BP/CP/IOC/IOP führen demnach, zumindest wenn genügend Verbindungsanforderungen vorliegen, quasisimultan jeweils die einzelnen Schritte der verschiedenen vermittlungstechnischen, sicherungstechnischen und/oder betriebstechnischen Funktionen für alle derzeitigen Verbindungen aus. Auf Details hierzu wird erst weiter unten eingegangen. Hier soll zunächst auf solche Aspekte eingegangen werden, die besonders eng das Wesen der Erfindung berühren.

Bei der Erfindung wird zwischen der Normalbetriebszeit und der Sonderbetriebszeit unterschieden. Im Normalbetrieb werden die beiden Blökke,z.B. MB3a und MB3b, jedes Speicherblockpaares, in diesem Fall also des Paares MB3a/MB3b, mikrosynchron parallel betrieben, wobei hier im Hauptspeicher CMY vier solche Speicherblockpaare MBO... MB3 angebracht sind,wovon jedes Paar für sich getrennt, simultan zu den anderen drei, steuerbar ist. Mindestens einer der Prozessoren BP,CP, IOC, IOP liest also unter von ihm gelieferten, evtl. umkodierten,Adressen in dieser Normalbetriebszeit mit Lese-Schreib-Betrieb Informationen jeweils aus beiden Blöcken eines Blockpaares, z.B. MB3a, MB3b, oder schreibt Informationen in beide Blöcke, z.B. MB3a, MB3b,ein. In dieser Normalbetriebszeit speichert demnach,wenn keine Störung vorliegt, der erste der beiden Blöcke,z.B. MB3a, unter einer seiner Adressen jeweils dieselbe Information wie der zweite Block,also in diesem Falle MB3b, unter derselben Adresse.

Zur Erhöhung der Betriebssicherheit werden die aus beiden Blöcken, vgl. MB3a, MB3b,in dieser Normalbetriebszeit gelesenen Informationen miteinander verglichen - und/oder es findet eine ständige Sich-Selbst-Überprüfung jedes der beiden Blöcke MB3a, MB3b, z.B. mittels EDC-Codes , statt. Wird bei solchen Prüfungen ein Fehler in den gelesenen Informationen festgestellt, wird jener Block, z.B. MB3b, abgeschaltet, aus dem der Fehler kommt. Dazu ist getrennt sowohl der erste als auch der zweite Block abschaltbar,um den Zugriff des jeweils betreffenden zugriffswilligen Prozessors, z.B. CPx, zum jeweils abgeschalteten Block, hier genannt "zweiter" Block, vgl. MB3b,zu sperren, zumindest um in dieser sog. Sonderbetriebszeit das Lesen aus diesem abgeschalteten zweiten Block MB3b zu verhindern; - wobei dann in dieser Sonderbetriebszeit alleine der erste Block, vgl. MB3a,voll im Lese-Schreibbetrieb betrieben wird, wobei also der erste Block MB3a dann auch alleine den Lesebetrieb und Schreibbetrieb für den jeweils betreffenden Prozessor, z.B.CPx, voll aufrechterhält.

Die Erfindung nutzt ferner einen Adressengenerator aus, der z.B. im IO-Prozessor IOC1 angebracht sein kann und der in dieser Sonderbetriebszeit systematisch nacheinander,zumindest in Etappen, alle Adressen der Blöcke, also auch die der Blöcke MB3a/MB3b, erzeugen kann.

Die Erfindung betrifft vor allem die Aktualisierung der im abgeschalteten zweiten Block, vgl. MB3b, gespeicherten Informationen, bevor vom Sonderbetrieb wieder auf Normalbetrieb übergegangen wird. Erfindungsgemäß wird nämlich besonders dieser zweite Block MB3b zunächst am Ende der Sonderbetriebszeit vor dem Übergang zur Normalbetriebszeit für die Aktualisierung der in ihm zu speichernden Informationen in besonderer Weise betrieben. Es wird nämlich schon vor diesem Übergang,während des normalen Schreibens in den ersten Block MB3a, dieselbe Information auch schon in den zweiten Block MB3b unter derselben Adresse geschrieben.Ferner wird vor dem Übergang - z.B. bevorzugt während einer oder mehreren längeren Pausen des Lese-Schreibbetriebes, in welchen vom Prozessor bzw. von den Prozessoren BP/CP/IOC/IOP weder der erste Block MB3a beschrieben wird noch aus diesem ersten Block MB3a,insbesondere zur Weiterverwertung im betreffenden Prozessor BP/CP/IOC/IOP, gelesen wird - der Adressengenerator angestoßen, damit dieser nach und nach alle Adressen des ersten und damit auch des zweiten Blocks MB3a, MB3b an den ersten und den zweiten Block MB3a, MB3b liefert, wobei die dabei aus dem ersten Block MB3a gelesenen Informationen jeweils unter derselben Adresse in den zweiten Block MB3b eingeschrieben werden.

Auf diese Weise ist der ganze Speicherinhalt des zweiten Blockes MB3b - wieder oder erstmals - aktualisiert, sobald der Adressengenerator alle Adressen des Blockpaares MB3 lieferte, d.h. dann sind alle Informationen unter allen Adressen in beiden Blöcken MB3 identisch. Damit kann nun der Normalbetrieb - wieder oder erstmals - beginnen, d.h. es können beide Blöcke MB3 sowohl beim Lesen als auch beim Schreiben - wieder oder erstmals - parallel betrieben werden.

Im folgenden werden die Details des in der Figur gezeigten Beispieles näher erläutert. Es zeigt schematisch eine Multiprozessor-Zentralsteuereinheit eines Vermittlungssystems, bei welcher die Prozessoren BP, CP, IOC über das Bussystem B:CMY mit dem Hauptspeicher CMY kommunizieren. Bussysteme, welche den verschiedenen Prozessoren bzw. Rechnern einen wahlweisen Zugriff auf den daran angeschlossenen Hauptspeicher, vgl. CMY bzw. dessen Speicherbanken MB, mittels Arbitern ermöglichen, sind für sich in verschiedensten Varianten bekannt. Darunter gibt es auch außerordentlich komfortable, vielseitige, außerordentlich sichere Bussysteme mit gedoppelten Bussen und mit hoher Verfügbarkeit, vgl. z.B. die nicht vorveröffentlichte DE-OS 33 28 405. Das Bussystem ist dabei aus Sicherheitsgründen oft gedoppelt, so auch im hier in der Figur gezeigten Beispiel, vgl. B:CMYO und B:CMY1; evtl. sind auch die Prozessoren BP/CP/IOC gedoppelt. Jeder Prozessor BP/CP des in der Figur gezeigten Beispiels enthält neben der eigentlichen, übrigens ebenfalls gedoppelten, Prozessoreinheit PU bevorzugt jeweils auch noch einen eigenen prozessorindividuellen lokalen Speicher LMY. Die Prozessoren IOC haben acht besondere Ausgänge 0 bis 7 mit lokalen Bussen B:IOC, über die sie mit IO-Units IOP und periphere Einheiten MBG des Fernsprech-Vermittlungssystems, z.B. mit Leitungsgruppensteuerungen, Koppelnetz, Tongeneratoren, usw. kommunizieren. Meistens wirken nämlich diese peripheren Einheiten MBG mittelbar oder unmittelbar auf die Leitungen des Vermittlungsnetzwerkes ein, z.B. im Rahmen der Wegesuche, Durchschaltung, Signalisierung usw.. Diese peripheren Einheiten MBG sind hier ebenfalls gedoppelt, vgl. die Auskreuzungen der Leitungen. Sie besitzen im gezeigten Beispiel jeweils eigene IO-Units, vgl. IOP:MB. Es sind weitere solche IO-Units an die lokalen Busse B:IOC angeschlossen, vgl. IOP, welche jeweils zwar mit weiteren solchen peripheren Einheiten verbunden sind, die aber der Übersichtlichkeit wegen in der Figur nicht mehr gezeigt sind.

Diese IO-Units IOP:MB...IOP, bzw. deren lokale Busse B:IOC, sind über IO-Prozessoren IOC, vgl. IOCO, IOC1, mit dem Bussystem B:CMY verbunden. Durch Punkte wurde in der Figur angedeutet, daß noch weitere solche IO-Prozessoren IOC, insbesondere bei sehr großen Vermittlungssystemen, vorgesehen sein können.

Die peripheren Einheiten, vgl. MBG, sind jeweils mit verschiedenen der Prozessoren BP/CP, von Fall zu Fall anders verteilt, verbindbar - und/oder auch mit dem zentralen Hauptspeicher CMY, bzw. mit Teilen von dessen Banken MB, erfindungsgemäß verbindbar. Durch diese Verbindungen können Meldungen und/oder Anfragen von peripheren Einheiten MBG, und Meldungen und/oder Anfragen zu solchen peripheren Einheiten MBG hin, in den Normalbetriebszeiten und Sonderbetriebszeiten durchgeführt werden. Die vermittlungstechnischen Meldungen und/oder Anfragen einer peripheren Einheit MBG werden dabei bevorzugt autonom über die mit ihnen verbundenen IO-Prozessoren IOC per Ruf verteilt, indem das jeweils betreffende IO-Unit IOP, wenn es einen Ruf von der peripheren Einheit MBG erhält, dieser rufenden peripheren Einheit MBG einen der Prozessoren BP/CP, bzw. einen Teil des Hauptspeichers CMY bzw. MB, zuteilt bzw. über das Bussystem B:CMY zuteilen läßt. Diese Zuteilung eines speziellen Prozessors und/oder eines speziellen Teils des Hauptspeichers CMY/MB an die betreffende periphere Einheit MBG wird dann noch in einem Datenfeld abgespeichert, wobei dieses Datenfeld auch innerhalb einer Bank MB des Hauptspeichers CMY angebracht sein kann. Durch diese Abspeicherungen im Datenfeld sind, insbesondere unter Mitwirkung der jeweils betreffenden IO-Unit IOP der rufenden peripheren Einheit MBG, jene späteren Meldungen oder Anfragen der zur betroffenen Verbindung gehörenden peripheren Einheiten MBG,welche diesem Ruf nachfolgen, jeweils zum selben, vorher zugeteilten Prozessor CP bzw. zum selben Hauptspeicherteil MB sendbar, damit dort die vermittlungstechnischen Funktionen und/oder Registrierungen fortgesetzt werden können. Eine solche autonome Zuteilung per Ruf ermöglicht eine angenähert gleichmäßige Belastung aller Prozessoren BP/CP mit vermittlungstechnischen Funktionen - zumindest kann diese Zuteilung dann jeweils entsprechend der momentanen Auslastung der betreffenden Prozessoren CP so gesteuert werden, daß die dem Ruf folgenden Meldungen und/oder Anfragen wirklich jeweils rasch von einem der Prozessoren, der noch eine ausreichend freie Kapazität hat, bearbeitet werden können. Die Auswahl bzw. die Verteilung der Prozessoren BP/CP zur Durchführung der Funktionen - besonders derjenigen, welche durch einen Ruf einer peripheren Einheit ausgelöst werden - kann dabei zyklisch erfolgen, wobei aber bei Überlastung eines Prozessors CP/BP dieser Prozessor im zyklischen Auswahlverfahren übersprungen wird. Durch eine solche zyklische Verteilung der Aufgaben bzw. Rufe auf die betreffenden Prozessoren ist eine zu einem hohen Grad gleichmäßige Auslastung der Prozessoren erreichbar. Rasch werden im allgemeinen alle Prozessoren mindestens eine gewisse Teilauslastung aufweisen. Es wird auch ein Fehler, bzw. die Neigung zu fehlerhafter Verarbeitung, in den Prozessoren stets rasch findbar, wodurch mittels betriebstechnischer Funktionen, die bevorzugt von einem der Prozessoren BP durchgeführt werden, der betreffende fehlerhafte Prozessor vorläufig außer Betrieb gesetzt und beim zyklischen Verteilen jeweils übersprungen werden kann, wobei auch eine - evtl. teilweise - Selbstheilung der Zentralsteuereinheit, z.B. mittels Ersatzschaltungen und Rettung von Speicherinhalten durchgeführt werden kann.

Der Aufbau der einzelnen Organe dieses Multiprozessor-Rechners, z.B. der Prozessoren BP und CP, der Banken MB bzw. des Hauptspeichers CMY, der IO-Prozessoren IOC welche z.B. auch eine verschiedene Anzahl von lokalen Systembussen B:IOC (vgl. die Ausgänge 0...7 des IO-Prozessors IOCO) haben können, kann bei der Erfindung jeweils an sich beliebig sein. Sie müssen nur zur Schnittstelle des gewählten Bussystems B:CMY passen bzw. an dessen Aufbau bzw. Betriebsweise angepaßt werden, wenn ein solches Bussystem B:CMY eingefügt ist.

Die in der Figur gezeigten peripheren Einheiten MBG können ebenfalls an sich einen beliebigen Aufbau mit beliebigen Funktionen aufweisen. Sie können sowohl gerätetechnische Einheiten darstellen als auch spezielle vermittlungstechnische Teilfunktionen von peripheren Einheiten, welche einen größeren Komplex verschiedener Funktionen ausführen. Trotz der forderbaren hohen Verfügbarkeit genügt es im allgemeinen, diese peripheren Organe bzw. Einheiten über ungedoppelte, also einfach vorhandene IO-Units IOP:MB...IOP an die IO-Prozessoren IOC anzuschließen, wenn diese peripheren Einheiten, vgl. MBG, für sich über Auskreuzungen angeschlossen sind, vgl. die Figur. Diese IO-Units IOP und/oder die zugeörigen IO-Prozessoren IOC können für sich zusätzliche Prüfungsfunktionen aufweisen, um unkontrollierte Zugriffe zu den Prozessoren BP/CP/IOC und zum Hauptspeicher CMY/MB, welche auf Fehlern beruhen, zu erschweren.

Bei einem derzeit entwickelten Beispiel gem. der Figur wurden für die Prozessoren BP/CP z.B. jeweils SAB 80286-Mikroprozessoren verwendet , die jeweils über einen physikalischen Adressraum von 16 MByte ihrer lokalen Speicher LMY verfügen. Für die Prozessoren IOC wurden z.B. jeweils 8086-Bausteine verwendet. Die Prozessoren wurden zur Verbesserung der Fehlererkennung bevorzugt gedoppelt und waren dann jeweils nur paarweise abschaltbar.

Bei dem in der Figur gezeigten Beispiel ist, wie bereits oben beschrieben, der an das Bussystem B:CMY angeschlossene Hauptspeicher CMY aus vier verschiedenen, überdies in sich jeweils aus Sicherheitsgründen gedoppelten Banken MBO...MB3 aufgebaut. Im Prinzip können alle Prozessoren BP/CP/IOC/IOP über das Bussystem B:CMY Zugriff auf alle Daten des Hauptspeichers CMY bzw. auf alle Daten seiner Banken MB haben, soweit nicht - z.B. durch Beschränkung der Adressen - die Berechtigung des Zugriffs eingeschränkt wird .

Bei einem solchen Multiprozessor-Spezialrechner, den diese Multiprozessor-Zentralsteuereinheit darstellt, fordert, normalerweise simultan, eine statistisch willkürlich verteilte beliebige Mehrzahl der Prozessoren BP/CP/IOC einen Zugriff zum Hauptspeicher CMY bzw. zu meistens unterschiedlichen Blockpaaren MB davon. Dann wird abwechselnd diesen jeweils verschiedenen Prozessoren, z.B. CP1, CPx, IOCO, der Bus bzw. die Busse des Bussystems B:CMY zugeteilt, wobei eine Arbitrierung über die Reihenfolge des Zugriffs in für sich bekannter Weise entscheiden kann, so daß die betreffenden Prozessoren BP/CP/IOC zum an das Bussystem B:CMY angeschlossenen Hauptspeicher CMY/MB nacheinander bzw. abwechselnd, sowohl im Normalbetrieb als auch im Sonderbetrieb, entsprechend den Arbitrierungen bzw. Zuteilungen des Bussystems B:CMY, Zugriff haben - wobei an sich auch vorgesehen werden kann, daß bei Bedarf die betreffenden Prozessoren BP/CP/IOC auch mittelbar miteinander über den Hauptspeicher CMY/MB sowohl in Normalbetriebszeiten als auch in Sonderbetriebszeiten kommunizieren können.

Im allgemeinen kommuniziert jeder dieser betreffenden Prozessoren jeweils mit einem anderen Bereich im Hauptspeicher CMY. Um die Wartezeiten dieser Prozessoren zu verringern, enthält der Hauptspeicher CMY mehrere, im gezeigten Beispiel vier, Speicherbanken MB mit jeweils einer eigenen Speichersteuerung. Diese eigene Speichersteuerung steuert jeweils ihre Speicherbank MB unabhängig von den Speichersteuerungen der übrigen Speicherbanken MB. So können diese vier Speicherbanken sowohl in der Normalbetriebszeit als auch in der Sonderbetriebszeit simultan betrieben werden.

Ferner können auf dem Bussystem B:CMY nach dem Zeitmultiplexprinzip Zeitrahmen mit Zeitschlitzen bzw. Zeitkanälen eingerichtet sein, wobei jeder Speichersteuerung jeweils einer oder mehrere der Zeitkanäle fest zugeordnet sind, und wobei den betreffenden, eine Kommunikation anfordernden Prozessoren BP, CP, IOC zum quasisimultanen Zugriff auf die verschiedenen Speicherbanken MB jeweils Zeitschlitze bzw. Zeitkanäle zuteilbar sind. Dadurch kann die Dauer des zugeteilten Zeitschlitzes jeweils viel kürzer als die Dauer eines Speicherzyklusses sein. Daher ist bei dieser Weiterbildung zwar nur ein einziges gedoppeltes Bussystem B:CMY angebracht, auf dem aber der Informationsfluß durch Zeitmultiplexbetrieb quasisimultan, d.h. stark verdichtet ist, was zu einer Verminderung des Hardwareaufwandes für das Bussystem, verglichen mit je einem eigenen Bussystem pro Speicherbank MB, beiträgt.

Die Schreibzyklen können demnach auch bei dieser Weiterbildung,bei oder nach der Übernahme der Information in der Prozessor-Bussystem-Schnittstelle,autonom vom Bussystem B:CMY weitergeleitet werden. Eine sofortige Quittung an den kommunizierenden Prozessor ermöglicht dessen Sofortigen Weiterlauf, obwohl der betreffende Schreibzyklus zur Datenbank noch nicht abgeschlossen ist. Dies ermöglicht eine besonders hohe Kapazität bzw. Verarbeitungsgeschwindigkeit der Multiprozessor-Zentralsteuereinheit.

Die Lesezyklen zu einer Bank MB können sogar gemäß einer Weiterbildung der Erfindung so verschachtelt ablaufen, daß der Rücktransfer der gelesenen Daten zeitgleich zur Übertragung der Adresse für einen folgenden Lesezugriff erfolgen kann. Dies erhöht die Kapazität bzw. Verarbeitungsgeschwindigkeit nochmals deutlich.

Im Normalfall arbeiten die beiden Busse des Bussystems B:CMY parallel und behandeln identische Informationen. Die Arbitrierung wird vor der Zuteilung eines Zeitschlitzes an die Prozessoren BP/CP/IOC/IOP durchgeführt, um die Leistung des Bussystems B:CMY zu steigern. Die Prioritäten des Arbiters können PROM-programmierbar sein. Eine möglichst gleichmäßige Belastung aller Banken MB kann z.B. durch die Zuordnung der Adresse zu diesen Banken MB über niederwertige Adressenbits, bei einem Interleaving-Raster von z.B. 8 Bytes,erreicht werden.

## Patentansprüche

1. Verfahren zum Betrieb eines in einer Normalbetriebszeit parallel betriebenen Speicherblockpaares (MB3a, MB3b) mit
   - mindestens einem Prozessor (BP, CP, IOC), der unter von ihm gelieferten Adressen in der Normalbetriebszeit mit Lese-Schreib-Betrieb Informationen aus den beiden Blöcken (MB3a, MB3b) liest und in beide Blöcke einschreibt, wobei in dieser Normalbetriebszeit der erste der beiden Blöcke unter einer seiner Adressen jeweils dieselben Informationen speichert wie der zweite Block unter derselben Adresse,
   - mikrosynchronem Vergleich der aus beiden Blöcken (MB3a, MB3b), in der Normalbetriebszeit gelesenen Informationen und/oder mit ständiger Sich-Selbst-Überprüfung jedes Blockes (MB3a, MB3b),

- Abschaltbarkeit getrennt sowohl des ersten als auch des zweiten Blockes (MB3a, MB3b) zur Sperrung des Zugriffs des jeweiligen betreffenden zugriffswilligen Prozessors (z. B. CPx) zum jeweils abgeschalteten Block, hier genannt zweiter Block (MB3b), in einer Sonderbetriebszeit zumindest beim Lesen aus diesem abgeschalteten zweiten Block (MB3b), wobei dann alleine der erste Block (MB3a) voll im Lese-Schreib-Betrieb betrieben wird und dabei für den jeweils betreffenden Prozessor (CPx) zur Verfügung steht, und
- einem Adressengenerator (z. B. in IOC1), der in der Sonderbetriebszeit systematisch nacheinander alle Adressen der Blöcke erzeugen und an beide Blöcke liefern kann, so daß am Ende der Sonderbetriebszeit aus dem ersten Block (MB3a) gelesene Informationen jeweils unter derselben Adresse in den zweiten Block (MB3a) geschrieben werden können, wonach ab erneutem Beginn der Normalbetriebszeit beide Blöcke wieder parallel betrieben werden, insbesondere für einen mehrere solcher Blockpaare enthaltenden Hauptspeicher (CMy) einer Multiprozessor-Zentralsteuereinheit eines Vermittlungssystems, z. B. Fernsprech-Vermittlungssystems,
- und zunächst am Ende der Sonderbetriebszeit schon vor der genannten systematischen Adressenlieferung für die Aktualisierung der im zweiten Block (MB3b) zu speichernden Informationen während des Schreibens in den ersten Block (MB3a) erfolgendem Schreiben derselben Information in den zweiten Block unter derselben Adresse,

**dadurch gekennzeichnet,**

daß danach in der Sonderbetriebszeit die systematische Adressenlieferung an den ersten und den zweiten Block (MB2as, MB3b), aufgrund dessen die hierbei aus dem ersten Block (M3a) gelesenen Informationen jeweils unter derselben Adresse in den zweiten Block (MB3b) geschrieben werden, während mehrerer Pausen des Lese-Schreib-Betriebs erfolgt, in welchem vom Prozessor bzw. von den Prozessoren (CP, IOC) weder der erste Block (MB3a) zur Abspeicherung beschrieben noch aus diesem ersten Block (MB3a) zur Weiterverwertung im betreffenden Prozessor (CP, IOC) gelesen wird.

## Claims

1. Method for the operation of a pair of memory blocks (MB3a, MB3b) which are operated in parallel in a period of normal operation, having
    - at least one processor (BP, CP, IOC), which, in the period of normal operation in the read/write mode, reads items of information from addresses supplied by the processor out of the two blocks (MB3a, MB3b) and writes into both blocks, such that, in this period of normal operation, the first of the two blocks stores the same items of information in each case under one of its addresses as the second block does under the same address,
    - micro-synchronous comparison of the items of information read out from both blocks (MB3a, MB3b) in the period of normal operation and/or having continuous self-checking of each block (MB3a, MB3b),
    - the ability to switch off separately both the first and the second block (MB3a, MB3b) for blocking the access of the relevant affected processor (for instance CPx) wishing to make access to the respective switched-off block, referred to here as the second block (MB3b), in a period of special operation at least for reading out from this switched-off second block (MB3b), such that only the first block (MB3a) is then operated fully in the read/write mode and is thus available to the relevant affected processor (CPx), and
    - an address generator (for instance in IOC1), which generates all the addresses of the blocks systematically one after another in the period of special operation and can supply them to both blocks, so that, at the end of the period of special operation, items of information read out from the first block (MB3a) can in each case be written under the same address into the second block (MB3b), after which, from a renewed start of the period of normal operation, both blocks are operated in parallel again, preferably for a main memory (CMy), containing a plurality of such pairs of blocks, of a multiprocessor central control unit of a telecommunications system, for instance telephone exchange system,
    - and, at the end of the period of special operation, while writing into the first block (MB3a), the same information is written into the second block, under the same address, first of all, before the aforesaid systematic supply of addresses for the updating of the items of information to be stored in the second block (MB3b), characterised in that, after this, the systematic supply of addresses to the first and the second block (MB2as, MB3b) in the period of special operation, on the basis of which the items of information thus read out of the first block (M3a) are in each case written under the same address into the second block (MB3b), takes place during a plurality of pauses in the read/write mode, during which the first block (MB3a) is neither written for storage by the processor or by the processors (CP, IOC) nor is it read from this first block (MB3a) for further processing in the affected processor (CP, IOC).

**Revendications**

1. Procédé pour faire fonctionner un couple de blocs de mémoire (MB3a,MB3b) opérant en parallèle pendant une durée de fonctionnement normale, avec

 - au moins un processeur (BP,CP,IOC), qui, pendant la durée de fonctionnement normale selon le mode de lecture-enregistrement, lit, aux adresses qu'il délivre, une information à partir des deux blocs (MB3a, MB3b) et les enregistre dans les deux blocs, auquel cas, pendant cette durée normale de fonctionnement normal, le premier des deux blocs mémorise, dans l'une de ses adresses, respectivement les mêmes informations que le second bloc à la même adresse,
 - une comparaison micro-synchrone des informations lues pendant la durée de fonctionnement normal à partir des deux blocs (MB3a, MB3b) et/ou avec un auto-contrôle permanent de chaque bloc (MB3a, MB3b),
 - une capacité de déconnexion séparée aussi bien du premier que du second bloc (MB3a, MB3b) pour bloquer l'accès du processeur considéré respectif (par exemple CPx) qui cherche à en avoir l'accès, au bloc respectivement déconnecté, ici désigné comme étant le second bloc (MB3b), pendant une durée de fonctionnement particulière au moins lors de la lecture à partir de ce second bloc déconnecté (MB3b), auquel cas uniquement le premier bloc (MB3a) fonctionne entièrement lors du fonctionnement de lecture-enregistrement et est disponible pour le processeur (CPx) respectivement considéré, et

 - un générateur d'adresses (par exemple dans IOC1), qui peut produire systématiquement et successivement, pendant la durée de fonctionnement particulière, toutes les adresses des blocs et les envoyer aux deux blocs, de sorte qu'à la fin de la durée de fonctionnement particulière, des informations lues à partir du premier bloc (MB3a) peuvent être enregistrées respectivement à la même adresse dans le second bloc (MB3b), à la suite de quoi, lors d'un redémarrage de la durée de fonctionnement normal, les deux blocs fonctionnent à nouveau en parallèle, notamment pour une mémoire principale (CMy), qui contient plusieurs tels couples de blocs, d'une unité de commande centrale à multiprocesseurs d'un système de commutation, par exemple d'un système de commutation téléphonique, et

 - tout d'abord à la fin de la durée de fonctionnement particulière et déjà avant ladite délivrance systématique d'adresses pour l'actualisation des informations devant être mémorisées dans le second bloc (MB3b), un enregistrement, exécuté pendant l'enregistrement dans le premier bloc (MB3a), de la même information dans le second bloc et à la même adresse,

caractérisé par le fait qu'ensuite, pendant la durée de fonctionnement particulière, la délivrance systématique d'adresses au premier bloc et au second bloc (MB2as, MB3), sur la base duquel les informations lues à partir du premier bloc (M3a) sont enregistrées respectivement à la même adresse dans le second bloc (MB3b), s'effectue pendant plusieurs pauses du fonctionnement de lecture-enregistrement, pendant lequel ni le premier bloc (MB3a) n'est enregistré par le ou les processeurs (CP, IOC) pour la mémorisation, ni aucune lecture n'est faite à partir de ce premier bloc (MB3a) pour la poursuite de l'évaluation, dans le processeur considéré (CP, IOC).

BP0 BP1 CPx-1 CPx CP9

LMY LMY LMY LMY LMY

PU PU PU PU PU

MBG MBG

IOP:MB IOP:MB

B:IOC B:IOC

IOP IOP

0 7

PU IOC0 PU IOC1

B:CMY0

B:CMY1

MB0a MB3a CMY

MB0b MB3b